# EUROPÄISCHE PATENTSCHRIFT

(11) **EP 2 020 749 B1**
(45) Veröffentlichungstag und Bekanntmachung des Hinweises auf die Patenterteilung: **03.12.2014**
(21) Anmeldenummer: 08012363.1
(22) Anmeldetag: 09.07.2008
(51) Int. Cl.: H03K 17/567, H03K 17/687, H03K 17/06, H03K 19/018, H03K 17/16

(54) **Treiberschaltung zur Ansteuerung eines Leistungshalbleiterschalters**
Driver control for actuating a high performance semiconductor switch
Circuit d'excitation destiné à commander un commutateur semi-conducteur de puissance

(30) Priorität: 03.08.2007 DE 102007036728
(43) Veröffentlichungstag der Anmeldung: 04.02.2009
(73) Patentinhaber: SEMIKRON Elektronik GmbH & Co. KG, 90431 Nürnberg (DE)
(72) Erfinder: Mühlhöfer, Alexander, 90522 Oberasbach (DE); Königsmann, Gunther, 91058 Erlangen-Tennenlohe (DE); Hofmair, Markus, 91154 Roth (DE); Bode, Rüdiger, 90763 Fürth (DE)

(56) Entgegenhaltungen:
- EP-A1- 0 814 564
- EP-A2- 0 652 639
- US-A1- 2003 206 422
- US-B1- 6 208 185

## Beschreibung

Die Erfindung betrifft eine Treiberschaltung, die der Ansteuerung eines Leistungshalbleiterschalters dient.

Leistungshalbleiterschalter, z.B. ein IGBT (Insulated Gate Bipolar Transistor) müssen zur Ausführung eines Schaltvorgangs ein Schaltsignal erhalten. Dieses wird in der Regel von einer Logikschaltung, z.B. einem PLD (Programmable Logic Device), geliefert. Ein IGBT wird z.B. mit einer Spannung von +15 V eingeschaltet und mit einer Spannung von z.B. -15 V ausgeschaltet. Der Spitzenstrom zum Schalten bzw. Laden des Gates des IGBT kann mehrere Ampere betragen. Die programmierbare Logik arbeitet hierbei z.B. in einem Bereich zwischen Masse und 3,3 V und liefert Signale im Bereich von Stromstärken weniger mA. Die Logikschaltung an sich stellt also mit ihrem Steuersignal weder genügend Strom noch genügend Spannung zur Verfügung, um den Leistungshalbleiterschalter tatsächlich schalten zu können. Die von der programmierbaren Logik gelieferten Ströme und Spannungen müssen daher verstärkt werden, um den Leistungshalbleiterschalter tatsächlich schalten zu können. Zur Verstärkung des Logiksignals wird eine entsprechende Endstufe bzw. Treiberschaltung benötigt.

Bekannt ist es, als Endstufe bzw. in einer Treiberschaltung einen vollintegrierten Ansteuerbaustein, wie z.B. vom Typ LM5107 der Firma National Semiconductor oder eine vergleichbare integrierte Schaltung zu verwenden.
Eine weitere Schaltung ist in US 6,208,185 B1 gezeigt.

Eine derartige Lösung ist jedoch teuer und außerdem ist üblicherweise eine eigene Stromversorgung von beispielsweise 10 V für die Versorgung des integrierten Bausteins zur Verfügung zu stellen.

Aufgabe der vorliegenden Erfindung ist es, eine verbesserte Treiberschaltung bzw. Endstufe zur Zwischenschaltung zwischen eine programmierbare Logik und einen Leistungshalbleiterschalter anzugeben.

Die Erfindung geht von der Erkenntnis aus, dass ein von der erfindungsgemäßen Treiberschaltung anzusteuernder Leistungshalbleiterschalter ein Signal einer ersten Spannung gegen ein Bezugspotential - in der Regel Masse - benötigt, um eingeschaltet werden zu können und ein Signal einer zweiten Spannung gegen dieses Bezugspotential benötigt, um ausgeschaltet werden zu können. Außerdem steht zur Ansteuerung des Leistungshalbleiterschalters eine Logikschaltung zur Verfügung, welche zwischen einer dritten Spannung und dem Bezugspotential versorgt ist und folglich Schaltsignale mit Spannungen zwischen dem Bezugspotential und der dritten Spannung liefern kann.

Die Erfindung wird gelöst durch eine Treiberschaltung mit einem ersten und einem zweiten Ausgang. Der erste Ausgang dient zur Ansteuerung des Leistungshalbleiterschalters mit einem Signal der ersten Spannung, der zweite Ausgang dient zur Ansteuerung des Leistungshalbleiterschalters mit einem Signal der zweiten Spannung, jeweils gegen das Bezugspotential. Die Treiberschaltung weist außerdem einen ersten und zweiten Eingang auf, welche von der Logikschaltung ansteuerbar sind. Ein Ansteuern des ersten Eingangs bewirkt ein Schaltsignal am ersten Ausgang und ein Ansteuern am zweiten Eingang ein Schaltsignal am zweiten Ausgang. Die Treiberschaltung enthält einen Einschaltpfad, welcher den ersten Eingang und den ersten Ausgang aufweist. Der Einschaltpfad ist mit der ersten Spannung und dem Bezugspotential versorgt. Die Treiberschaltung enthält weiterhin einen Ausschaltpfad, welcher den zweiten Eingang und den zweiten Ausgang aufweist und der von der dritten Spannung und der zweiten Spannung versorgt ist. Ein- und Ausschaltpfad, jeweils für sich, weisen je einen Pegelwandler auf, der wiederum den ersten oder zweiten Eingang, je nach Ein- oder Ausschaltpfad, enthält. Beide Pfade weisen einen vom jeweiligen Pegelwandler angesteuerten Stromverstärker und eine jeweilige, vom Stromverstärker angesteuerte Endstufe auf. Die jeweilige Endstufe des jeweiligen Pfades enthält den ersten oder zweiten Ausgang.

Die gesamte Treiberschaltung weist damit den Vorteil auf, dass sie lediglich durch die ohnehin für die Ansteuerung des Leistungshalbleiterschalters benötigten Spannungen versorgt werden muss, nämlich der ersten bis dritten Spannung und dem Bezugspotential. Eine zusätzliche Spannungsversorgung ist nicht notwendig. Der jeweilige Ansteuerpfad, also Ein- oder Ausschaltpfad, können direkt von der Logikschaltung angesteuert werden, d.h. mit Signalen im Bereich zwischen Bezugspotential und der dritten Spannung angesteuert werden und liefern dennoch an ihren Ausgängen ein Schaltsignal der ersten Spannung gegen das Bezugspotential zum Einschalten des Leistungshalbleiterschalters und der zweiten Spannung gegen das Bezugspotential zum Ausschalten des Leistungshalbleiterschalters.

Die zeitliche Steuerung der Ein- und Ausschaltvorgänge, d.h. der Aktivierung von erstem und zweitem Ausgang und dadurch die entsprechende Erzeugung einer Schaltspannung an erstem und zweitem Ausgang wird durch die Logikschaltung übernommen. Hierdurch kann also eine zeitliche Überlappung der Ansteuerung der beiden Endstufen im Ein- und Ausschaltpfad erreicht werden.

Der Pegelwandler, der Stromverstärker und die Endstufe können jeweils für sich diskret aufgebaut sein. Ein diskreter Aufbau, also die Verwendung nicht oder nur niedrig integrierter Bauelemente, wie z.B. Bipolar- oder MOSFET-Transistoren, in diskreter Zusammenschaltung ist wesentlich kostengünstiger als die Verwendung eines oben erwähnten vollintegrierten Ansteuerbausteins.

Der Pegelwandler kann einen mit seinem Steuereingang mit dem jeweiligen Eingang des Ein- oder Ausschaltpfades verbundenen Transistor mit Vorwiderständen enthalten. In der Regel ist dann der Transistor mit Kollektor und Emitter über jeweils einen ohmschen Widerstand auf die beiden versorgenden Spannungen des jeweiligen Pfades geführt, die Basis ist auf den jeweiligen Eingang geführt und zwischen Basis und Emitter ist ein Eingangswiderstand geschaltet.

Der Stromverstärker kann ein zwei Transistoren enthaltender Emitterfolger sein. Z.B. bei der eben genannten Ausführungsform wird dann der Kollektoranschluss des Transistors des Pegelwandlers parallel auf zwei Basen zweier Transistoren geführt, welche mit ihren Kollektoren und Emittern in Reihenschaltung zwischen die beiden, den jeweiligen Pfad versorgenden Spannungen geschaltet sind.

Die Endstufe kann einen mit seinem Leistungsausgang mit dem Ausgang verbundenen MOSFET mit Vorwiderstand enthalten. Z.B. für die oben genannte Ausführungsform ist dann der Source-Anschluss des MOSFET mit der jeweiligen ersten oder zweiten Spannung im jeweiligen Pfad verbunden, der Drain-Anschluss ist auf den Ausgang geführt, das Gate ist mit den miteinander verbundenen Emittern des Emitterfolgers verbunden und zwischen Gate und Source ist ein ohmscher Eingangswiderstand geschaltet.

Die erste Spannung beträgt vorzugsweise +15V, die zweite Spannung -8V bis -15V und die dritte Spannung +3,3V, das Bezugspotential ist vorzugsweise Masse. Derartige Spannungskonstellationen sind z.B. für den Betrieb eines IGBT durch eine entsprechende PLD-Logikschaltung übliche Spannungswerte.

Wie bereits erwähnt, kann die Logikschaltung ein PLD sein.

Wie ebenfalls bereits erwähnt, kann die Treiberschaltung eine solche zur Ansteuerung eines IGBT als Leistungshalbleiterschalter sein.

Für eine weitere Beschreibung der Erfindung wird auf die Ausführungsbeispiele der Zeichnungen verwiesen. Es zeigen, jeweils in einer schematischen Prinzipskizze:
- Fig.1: eine erfindungsgemäße Treiberschaltung im Überblick,
- Fig.2: den Ein- und Ausschaltpfad der Treiberschaltung aus Fig. 1 im Blockschaltbild,
- Fig.3: den Ein- und Ausschaltpfad aus Fig. 2 im Detail.

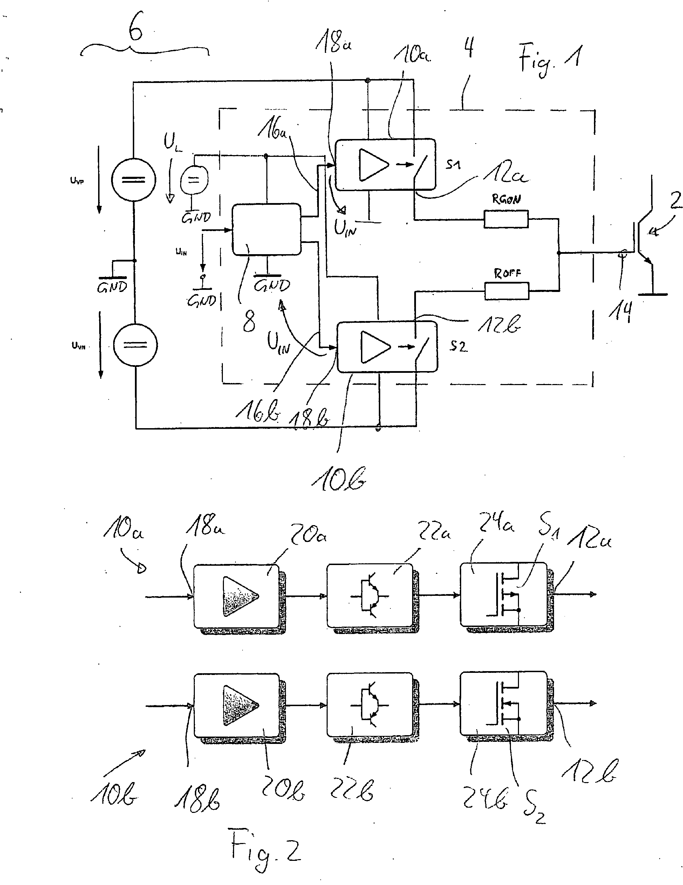

Fig. 1 zeigt eine Halbleiterschalteranordnung, bestehend aus einem IGBT 2 als Halbleiterschalter, einem diesen ansteuernden Treiber 4 und einer Spannungsversorgung 6 für den Treiber 4 bzw. zur Ansteuerung des IGBT 2.

Der Treiber 4 umfasst ein PLD 8, welches die logische Steuerfunktionalität für den IGBT 2 bereitstellt, sowie zwei separate, vom PLD 8 angesteuerte Ansteuerkanäle 10a und 10b. Der Ansteuerkanal 10a dient hierbei zum Einschalten des IGBT 2 und ist mit seinem Ausgang 12a über einen Widerstand RGON mit dem Steuereingang 14 des IGBT 2 verbunden. Der Ansteuerkanal 10b dient zum Ausschalten des IGBT 2 und ist mit seinem Ausgang 12b über einen Widerstand ROFF ebenfalls mit dem Steuereingang 14 verbunden.

Jeder Ansteuerkanal 10a,b enthält hierbei jeweils einen Halbleiterschalter S1 und S2, welche vom PLD 8 gesteuert werden und über die betreffenden Widerstände RGON und ROFF eine jeweilige Einschaltspannung U_{VP} von +15 V oder eine Ausschaltspannung U_{VN} von -8V bis -15 V auf den Steuereingang 14 des IGBT schalten. Beide Spannungen U_{VP} und U_{VN} sind Teil der Spannungsversorgung 6, welche außerdem noch eine Logikspannung U_{L} von +3,3V zur Verfügung stellt, mit welcher in erster Linie der PLD 8 betrieben wird. Das Bezugspotential für alle Spannungen ist die Masse GND.

Der Ansteuerkanal 10a ist durch die Versorgungsspannung U_{VP} gegen Masse GND versorgt. Der Ansteuerkanal 10b ist durch die Logikspannung U_{L} gegen die (negative) Ausschaltspannung U_{VN} versorgt.

Der PLD 8 erzeugt Steuerspannungen, welche über die Steuerleitungen 16a,b an die jeweiligen Eingänge 18a,b der Ansteuerkanäle 10a,b geliefert werden und im Bereich zwischen 0V, also GND und der Logikspannung U_{L} von +3,3V liegen.

Fig. 2 zeigt die Ansteuerkanäle 10a,b in detaillierterer bzw. Blockdarstellung. Jeder der Ansteuerkanäle 10a,b ist vom jeweiligen Eingang 18a,b bis zum Ausgang 12a,b in gleicher Weise aufgebaut, nämlich als Reihenschaltung aus einem Pegelwandler 20a,b, einem Stromverstärker 22a,b und einer Endstufe 24a,b. Der Ansteuerkanal 10a enthält hierbei als Transistor S₁ einen P-Kanal-Feldeffekt-Transistor in der Endstufe 24a, der Steuerkanal 10b als Transistor S₂ einen N-Kanal-Feldeffekt-Transistor in der Endstufe 24b.

Die zeitliche Überlappung der beiden ein- bzw. ausgeschalteten Endstufen-Transistoren S₁ und S₂ wird über die Eingänge 18a,b, also durch das PLD 8 als ein darin ablaufendes, nicht dargestelltes Programm realisiert.

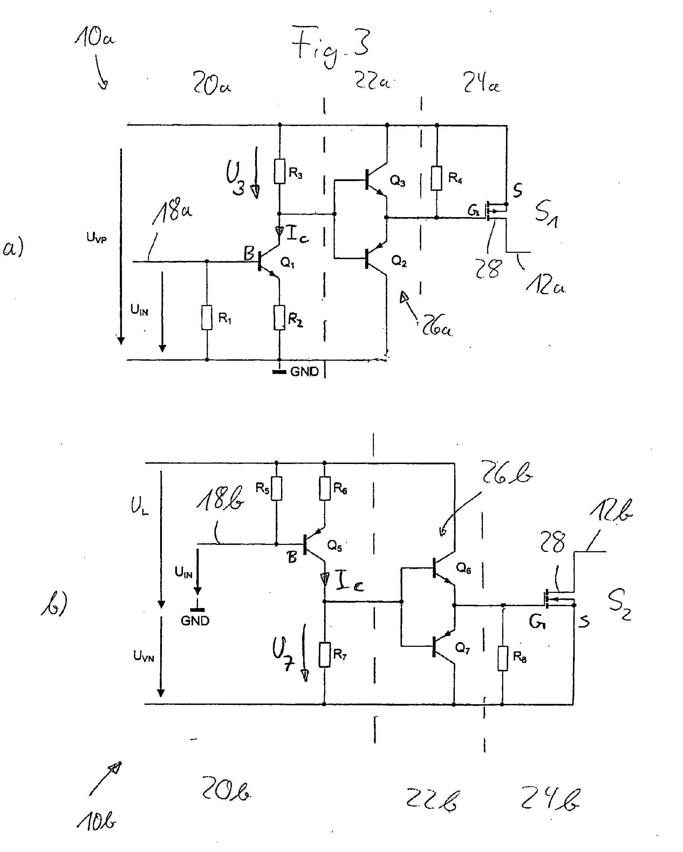

Fig. 3a zeigt in einer nochmals detaillierteren Darstellung den Ansteuerkanal 10a; Fig. 3b den Ansteuerkanal 10b. Der Eingangswiderstand R₁ zwischen der Basis B des Transistors Q₁ und Masse GND wird benötigt, um im Falle einer hochohmigen Ansteuerstufe, d.h. eines hochohmigen Ausgangs des PLD 8, die Basis B des Transistors Q₁ auf ein definiertes Potential, nämlich Masse GND zu legen, so dass der Transistor Q₁ sicher ausgeschaltet bleibt.

Eine positive Ansteuerspannung U_{IN} vom PLD 8 an der Basis B von Q₁ schaltet den Transistor Q₁ ein und lässt einen definierten Kollektorstrom durch den Transistor Q₁ fließen. Dieser Strom wird eingeprägt durch die Eingangsspannung U_{IN} und den Widerstand R₂. Durch diesen definierten Kollektorstrom von Q₁, fällt am Widerstand R₃ eine definierte Spannung U₃ ab. Diese Spannung U₃ wird von dem nach geschalteten Emitterfolger 26a, bestehend aus den Transistoren Q₂ und Q₃, stromverstärkt und so das Gate G von S₁ geladen. Die Spannung am Widerstand R₄ steigt und schaltet den Transistor S₁ bei überschreiten seiner Eingangsschwelle ein. Der durch den Transistor S₁ dargestellte Schalter schließt sich. Der IGBT 2 wird eingeschaltet. Der Leistungsausgang 28 des Transistors S₁ ist aktiv.

Sinkt die Eingangsspannung U_{IN} an der Basis des Transistors Q₁ auf GND-Potential ab, so verringert sich der Stromfluss durch den Transistor Q₁, und die Spannung U₃ an R₃ sinkt. Die Spannung U₃ wird von dem nach geschalteten Emitterfolger 26b stromverstärkt, das Gate G von S₁ entladen und auf das Potential von Uᵥₚ gezogen. Sobald die Einschaltschwelle von S₁ unterschritten wird, beginnt der Endstufentransistor S₁ zu sperren. Der durch S₁ dargestellte Schalter öffnet sich. Der IGBT 2 wird nicht länger mit einem Einschaltimpuls der Spannung U_{VP} versorgt. Der Leistungsausgang 28 des Transistors S₁ läuft leer.

Der Widerstand R₄ zwischen Gate G und Source S von S₁ entlädt das Gate G komplett, so dass im ausgeschalteten Zustand von S₁ keine Spannung zwischen Gate G und Source S anliegt.

In Fig. 3b wird der Eingangswiderstand R₅ zwischen der Basis B des Transistors Q₅ und der Spannung U_{L} benötigt, um im Falle eines hochohmigen Ausgangs des PLD 8 und damit an der Basis B des Transistors Q₅ eben diese Basis B auf ein definiertes Potential, nämlich der Spannung U_{L}, zu legen, so dass der Transistor Q₅ sicher ausgeschaltet bleibt. Der EndstufenTransistor S₂ ist nämlich dann sicher ausgeschaltet, wenn die Eingangsspannung U_{IN} gleich der Spannung U_{L} ist.

Wird die Spannung an der Basis B von Q₅ auf Masse GND gezogen, schaltet der Transistor Q₅ ein und lässt einen definierten Kollektorstrom I_{C} durch den Transistor Q₅ fließen. Dieser Strom I_{C} wird eingeprägt von der Spannung zwischen U_{L} und der Eingangsspannung U_{IN} und dem Widerstand R₆. Durch diesen definierten Kollektorstrom I_{C} von Q₅ fällt über R₇ eine definierte Spannung U₇ ab. Diese Spannung U₇ wird von dem nach geschalteten Emitterfolger 26b stromverstärkt und das Gate G von S₂ geladen. Die Spannung an R₈ steigt und schaltet S₂ bei überschreiten seiner Eingangsschwelle ein. Der durch S₂ dargestellte Schalter schließt sich. Der IGBT 2 wird mit einem Schaltimpuls der Spannung U_{VN} versorgt und dadurch abgeschaltet. Der Leistungsausgang 28 des Transistors S₂ ist also aktiv.

Steigt die Eingangsspannung U_{IN} an der Basis B von Q₅ auf U_{L} an, so verringert sich der Stromfluss I_{C} durch den Transistor Q₅ und die Spannung U₇ an R₇ sinkt ebenfalls. Die Spannung U₇ wird von dem nach geschalteten Emitterfolger 26b stromverstärkt, das Gate G von S₂ entladen und auf das Potential der Spannung U_{VN} gezogen. Sobald die Einschaltschwelle von S₂ unterschritten wird, beginnt der Endstufentransistor S₂ zu sperren. Der durch S₂ dargestellte Schalter S2 öffnet sich. Der IGBT 2 erhält nicht länger einen Ausschaltimpuls der Spannung U_{VN}.

Der Widerstand R₈ zwischen Gate G und Source S von S₂ entlädt das Gate G komplett, so dass im ausgeschalteten Zustand von S₂ keine Spannung zwischen Gate G und Source S anliegt. Der Leistungsausgang 28 des Transistors S₂ läuft leer.

## Patentansprüche

1. Treiberschaltung (4) mit einem ersten (12a) und zweiten Ausgang (12b) zur Ansteuerung eines mit einem Signal einer
ersten Spannung (U_{VP}) gegen ein Bezugspotential (GND) einschaltbaren und mit einem Signal einer zweiten Spannung (U_{VN}) gegen das Bezugspotential (GND) ausschaltbaren Leistungshalbleiterschalters (2), und mit einem ersten (18a) und zweiten Eingang (18b) zur Ansteuerung durch ein Signal (U_{IN}) einer mit einer dritten Spannung (U_{L}) und dem Bezugspotential (GND) versorgten Logikschaltung (8), mit einem zwischen der ersten Spannung (U_{VP}) und dem Bezugspotential (GND) versorgten, den ersten Eingang (18a) und ersten Ausgang (12a) aufweisenden Einschaltpfad (10a) und einem zwischen der dritten Spannung (U_{L}) und der zweiten Spannung (U_{VN}) versorgten, den zweiten Eingang (18b) und den zweiten Ausgang (12b) aufweisenden Ausschaltpfad (10b), wobei Ein- (10a) und Ausschaltpfad (10b) je einen den jeweiligen Eingang (18a,b) aufweisenden Pegelwandler (20a,b), einen vom Pegelwandler (20ab,b) angesteuerten Stromverstärker (22a,b) und eine vom Stromverstärker (22a,b) angesteuerte, den jeweiligen Ausgang (12a,b) aufweisende Endstufe (24a,b) enthalten.

2. Treiberschaltung (4) nach Anspruch 1, bei der der Pegelwandler (20a,b), der Stromverstärker (22a,b) und die Endstufe (24a,b) diskret aufgebaut sind.

3. Treiberschaltung (4) nach Anspruch 1 oder 2, bei der der Pegelwandler (20a,b) einen mit seinem Steuereingang (13) mit dem Eingang (18a,b) verbundenen Transistor (Q₁,Q₅) mit Vorwiderständen (R₁₋₃, R₅₋₇) enthält.

4. Treiberschaltung (4) nach einem der vorhergehenden Ansprüche, bei der der Stromverstärker (22a,b) ein zwei Transistoren (Q₂₋₃, Q₆₋₇) enthaltender Emitterfolger (26a,b) ist.

5. Treiberschaltung (4) nach einem der vorhergehenden Ansprüche, bei der die Endstufe (24a,b) einen mit seinem Leistungsausgang (28) mit dem Ausgang (12a,b) verbundenen MOSFET (S1,S2) mit Vorwiderstand (R₄,R₈) enthält.

6. Treiberschaltung (4) nach einem der vorhergehenden Ansprüche, bei der zumindest annähernd die erste Spannung (U_{VP}) +15V, die zweite Spannung (U_{VN}) im Bereich -8V bis -15V und die dritte Spannung (U_{L}) +3,3V, und das Bezugspotential (GND) Masse ist.

7. Treiberschaltung (4) nach einem der vorhergehenden Ansprüche, bei der die Logikschaltung (8) ein PLD ist.

8. Treiberschaltung (4) nach einem der vorhergehenden Ansprüche, die eine Treiberschaltung zur Ansteuerung eines IGBT als Leistungshalbleiterschalter (2) ist.

## Claims

1. Driver circuit (4) with a first (12a) and second output (12b) for actuating a power semiconductor switch (2) that can be switched on with a signal of a first voltage (U_{VP}) in respect of a reference potential (GND) and switched off with a signal of a second voltage (U_{VN}) in respect of the reference potential (GND), and with a first (18a) and second input (18b) for actuation by a signal (U_{IN}) from a logic circuit (8) powered by a third voltage (U_{L}) and the reference potential (GND), with a switch-on path (10a) powered between the first voltage (U_{VP}) and the reference potential (GND) comprising the first input (18a) and first output (12a), and a switch-off path (10b) powered between the third voltage (U_{L}) and the second voltage (U_{VN}) comprising the second input (18b) and the second output (12b), wherein the switch-on path (10a) and switch-off path (10b) each contain a level converter (20a,b) comprising the respective input (18a,b), a current amplifier (22a,b) actuated by the level converter (20a,b), and an end stage (24a,b) comprising the respective output (12a,b) actuated by the current amplifier (22a,b).

2. Driver circuit (4) according to Claim 1, in which the level converter (20a,b), the current amplifier (22a,b) and the end stage (24a,b) have discrete construction.

3. Driver circuit (4) according to Claim 1 or 2, in which the level converter (20a,b) includes a transistor (Q₁, Q₅) with series resistors (R₁₋₃, R₅₋₇) connected with its control input (13) to the input (18a,b).

4. Driver circuit (4) according to one of the preceding claims, in which the current amplifier (22a,b) is an emitter follower (26a,b) containing two transistors (Q₂₋₃, Q₆₋₇).

5. Driver circuit (4) according to one of the preceding claims, in which the end stage (24a,b) includes a MOSFET (S1, S2) with series resistor (R₄, R₈) connected with its power output (28) to the output (12a,b).

6. Driver circuit (4) according to one of the preceding claims, in which at least approximately the first voltage (U_{VP}) is +15 V, the second voltage (U_{VN}) is in the range -8 V to -15 V, and the third voltage (U_{L}) is +3.3 V and the reference potential (GND) is ground.

7. Driver circuit (4) according to one of the preceding claims, in which the logic circuit (8) is a PLD.

8. Driver circuit (4) according to one of the preceding claims which is a driver circuit for actuating an IGBT as a power semiconductor switch (2).

## Revendications

1. Circuit d'attaque (4) comportant des première (12a) et deuxième (12b) sorties pour commander un commutateur à semi-conducteur de puissance (2) pouvant être activé par un signal ayant une première tension (U_{VP}) par rapport à un potentiel de référence (GND) et pouvant être désactivé par un signal ayant une deuxième tension (U_{VN}) par rapport au potentiel de référence (GND), et comportant des première (18a) et deuxième (18b) entrées destinées à commander au moyen d'un signal (U_{IN}) un circuit logique (8) alimenté par une troisième tension (U_{L}) et la tension de référence (GND), comportant un trajet d'activation (10a) comprenant la première entrée (18a) et la première sortie (12a) et alimenté entre la première tension (U_{VP}) et le potentiel de référence (GND) et un trajet de désactivation (10b) comprenant la deuxième entrée (18b) et la deuxième sortie (12b) et alimenté entre la troisième tension (U_{L}) et la deuxième tension (U_{VN}), dans lequel les trajets d'activation (10a) et de désactivation (10b) contiennent chacun un convertisseur de niveau (20a,b) comprenant l'entrée respective (18a,b), un amplificateur de courant (22a,b) commandé par le convertisseur de niveau (20a,b) et un étage final (24a,b) comprenant la sortie (12a,b) respective et commandé par l'amplificateur de courant (22a,b).

2. Circuit d'attaque (4) selon la revendication 1, dans lequel le convertisseur de niveau (20a,b), l'amplificateur de courant (22a,b) et l'étage final (24a,b) sont réalisés de manière discrète.

3. Circuit d'attaque (4) selon la revendication 1 ou 2, dans lequel le convertisseur de niveau (20a,b) contient un transistor (Q₁, Q₅) comportant des résistances de polarisation (R₁₋₃, R₅₋₇) et connecté à l'entrée (18a,b) par son entrée de commande (13).

4. Circuit d'attaque (4) selon l'une quelconque des revendications précédentes, dans lequel l'amplificateur de courant (22a,b) est un suiveur d'émetteur (26a,b) contenant deux transistors (Q₂₋₃, Q₆₋₇).

5. Circuit d'attaque (4) selon l'une quelconque des revendications précédentes, dans lequel l'étage final (24a,b) contient un MOSFET (S1, S2) comportant des résistances de polarisation (R₄, R₈) et connecté à la sortie (12a,b) par sa sortie de puissance (28).

6. Circuit d'attaque (4) selon l'une quelconque des revendications précédentes, dans lequel la première tension (U_{VP}) est au moins approximativement de +15V, la deuxième tension (U_{VN}) se situe au moins approximativement dans l'intervalle de -8V à -15V et la troisième tension (U_{L}) est au moins approximativement de +3,3V, et le potentiel de référence (GND) est la masse.

7. Circuit d'attaque (4) selon l'une quelconque des revendications précédentes, dans lequel le circuit logique (8) est un PLD.

8. Circuit d'attaque (4) selon l'une quelconque des revendications précédentes, **caractérisé en ce qu'**il s'agit d'un circuit d'attaque destiné à commander un IGBT en tant que circuit à semi-conducteur de puissance (2).
